# EUROPEAN PATENT APPLICATION

(11) **EP 1 684 308 A1**
(43) Date of publication of application: **26.07.2006**
(21) Application number: 06100526.0
(22) Date of filing: 18.01.2006
(51) Int. Cl.: G11C 16/34, G11C 16/10, G11C 16/04

(54) **Methods for preventing fixed pattern programming**

(30) Priority: 19.01.2005 US 644569 P
(71) Applicant: Saifun Semiconductors Ltd., Netanya 42505 (IL)
(72) Inventor: Shapir, Assaf, 55401 Kiryat Ono (IL); Eisen, Shai, Tel Aviv 65275 (IL); Cohen, Guy, Yaad 20155 (IL); Danon, Kobi, Rishon Lezion (IL)
(74) Representative: Andersson, Björn E.

(57) **Abstract**

A method for preventing fixed pattern programming, the method including programming data into a pattern of memory cells in a memory array, and fixed pattern programming by periodically scrambling the data so that the data is stored in a different pattern of memory cells in the memory array.

## Description

### FIELD Of THE INVENTION

The present invention relates generally to operation memory cells of non-volatile memory (NVM) arrays, such as programming and erasing, and particularly to methods for preventing large differences in the program and erase history of cells, such as by data scrambling.

### BACKGROUND OF THE INVENTION

Modern day non-volatile memory products incorporate the ability to electrically program and erase the memory cells. In most cases, the erase operation is performed on a subset of cells and not individually cell-by-cell, as normally performed during the programming operation. This means that erasure conditions are applied to the subset until the last (slowest) cell finishes erasure, including verification that the cell has passed a predetermined level (erase verify).

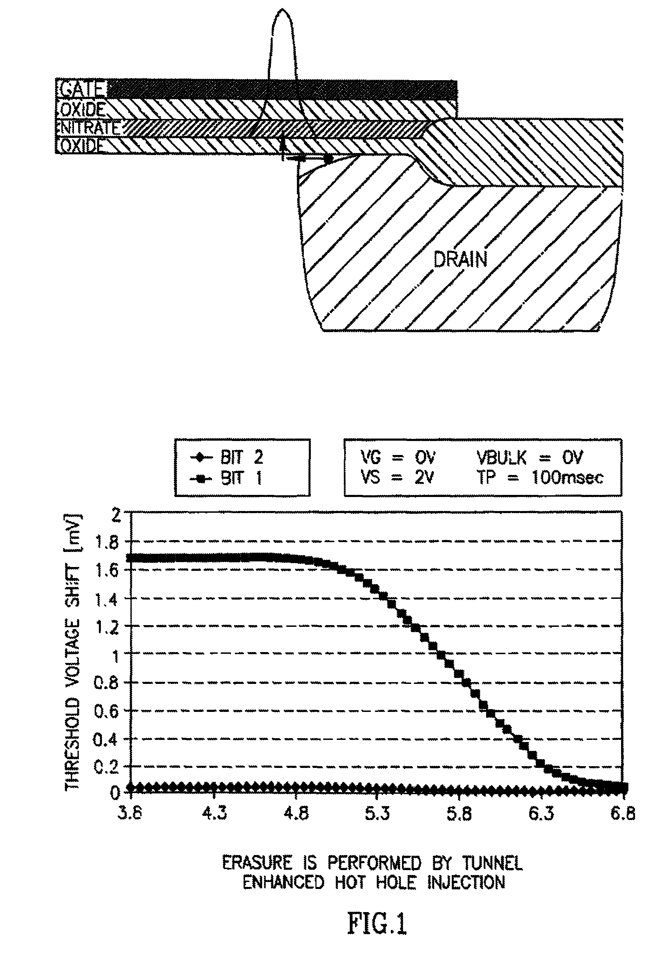

Memory products incorporating tunneling enhanced hot hole injection during erasure, as in NROM (nitride read-only memory) technology, require high biasing of the transistor junction to create the injected holes, through band-to-band tunneling, as may be seen in Fig. 1, Charge injection must be controlled to insure proper device operation, and accordingly, step and verify algorithms are typically implemented. In a typical algorithm, charge is injected at a certain bias following by a verify operation to ascertain whether the cell has reached its destination. If the destination has not been achieved, stronger charge injection is initiated via a higher bias and vice versa.

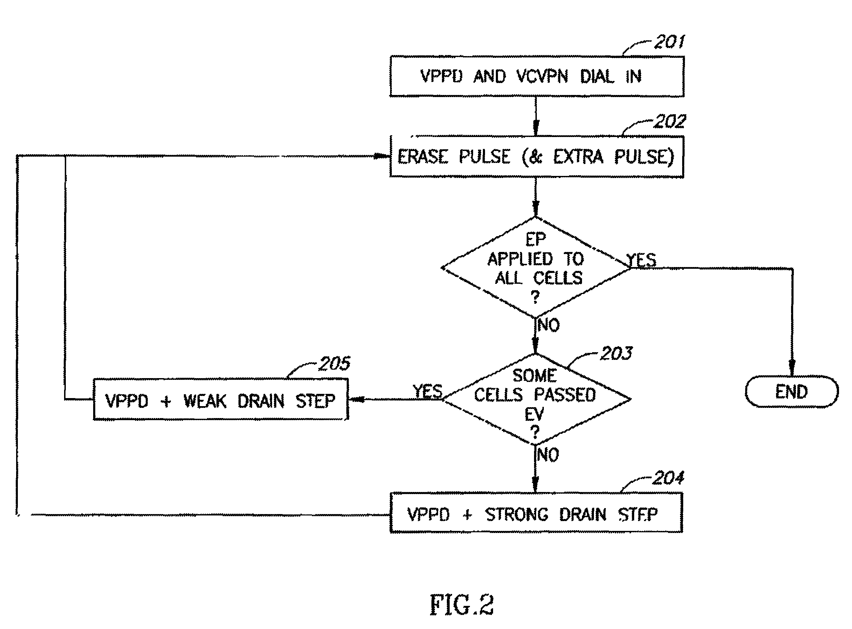

Reference is now made to Fig. 2, which illustrate a typical flow diagram of an crase algorithm of the prior art for NROM devices.

An erase pulse may be selected for erasing bits of the cells, comprising selecting ("dialing in") a negative gate voltage (Vg or Vcvpn - voltage from a charge pump) and a positive drain voltage (Vppd) (step 201). The erase pulse may then be applied to the bits in a cell ensemble (step 202). The threshold voltage Vt of the cells may be read with an erase verify step (step 203) that checks if the memory cell threshold voltage has been lowered to an erase verify (EV) voltage level or not.

If no cells have passed EV, then a new Vppd level may be set (dialed in) with a strong (i.e., large) increment (step 204). If some cells have passed EV. then a new Vppd level may be set with a weak (i.e.. relatively smaller) increment (step 205). The process continues until the erase pulse has been applied to all cells. Each subgroup may receive an extra erase pulse at a higher level than the last pulse used to reach full erasure for improving reliability. Application of additional pulses is taught in various patent documents, such as US Patent 6.700.818 and US Patent Applications 20050117395 and 20050058005, all assigned to the present assignee of the present application, the disclosures of which are incorporated herein by reference.

For tunneling enhanced hot hole injection, the process shown in Fig. 2 usually has to be performed on both sides of the memory cell separately, resulting in longer erase time and lower performance.

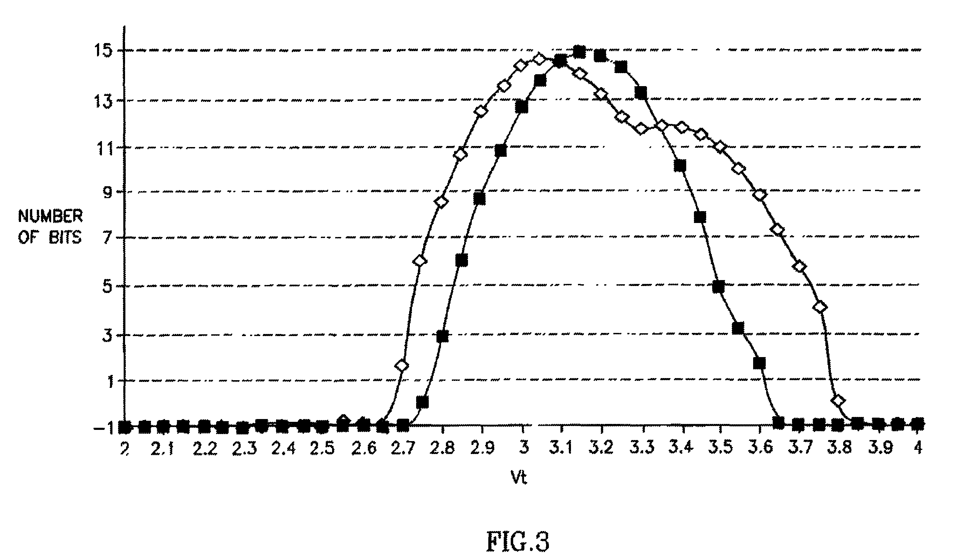

As the data stored in a subset of cells will most likely be random in nature, some of the cells will be in the programmed state and some will be in the erased state, prior to the erasure operation. Thus, if no special actions are taken, it is possible that a previously programmed cell upon which the erase operation is performed may reach a threshold level near or at the erase verify level, while cells which were not programmed may become over-erased, wherein the threshold voltage is substantially below the erase verify level. This may be seen in Fig. 3, which shows a prior art threshold voltage distribution of a subset of cells in their native state, before any operation was performed, and after erasure, where only a subgroup was previously programmed. The erased cell distribution has two peaks. The higher peak is the threshold voltage distribution of the previously programmed cells, while the lower peak is that of the non-programmed cells, i.e., the cells that were over-erased.

Several concerns arise from the over-erased situation. Over-erased cells may become leaky, i.e., conduct current without being biased to the "on" state (positive gate voltage for an n-MOSFET based memory cell). Over-erased cells may become hard to program, i.e., require excessive voltages and time to bring them to the programmed state (above a predefined level, program verify level). A substantial difference in the operating conditions (program and erase) may develop between cells which have been over-erased and cells which have not been over-erased. The sum of these effects may result in failure of the memory device, i.e., loss of data integrity.

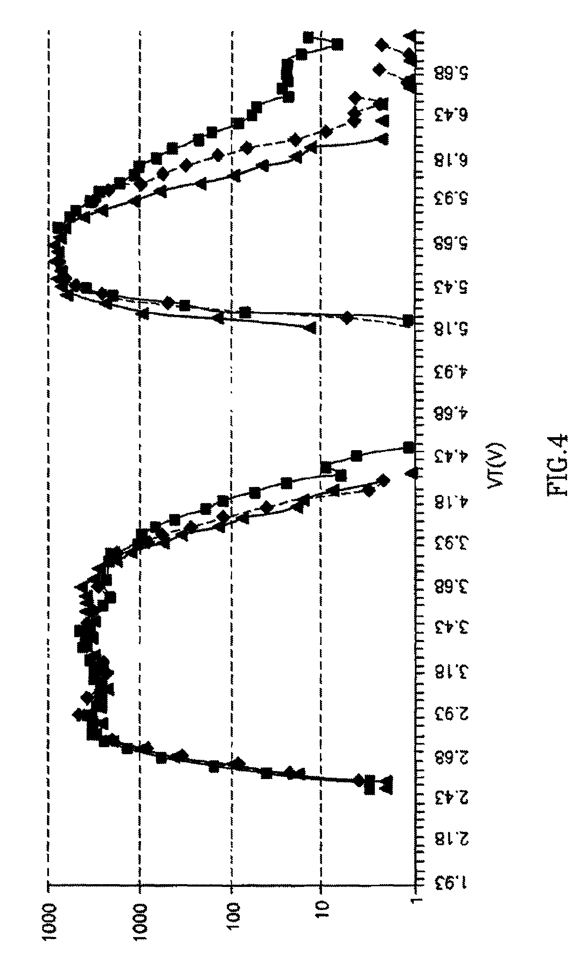

Reference is now made to Fig. 4, which illustrates prior art threshold voltage distributions in a subgroup of cells in a memory array following extensive cycling of a fixed pattern (10⁵ cycles) and a subsequent programming of a checkerboard pattern. A programming tail is shown to have formed, due to the lack of sufficient over-erasure prevention measures.

Prior an methods to prevent over-erasure of cell include partitioning of the erase subgroup, which has the advantage that smaller erase subgroups insure better erase uniformity. However, disadvantages include additional overhead (reduced performance) and design complexity. Another prior art method involves programming before erasure, which ensures that cells will not constantly go through erasure without ever being programmed. However, this carries a substantial performance penalty in time and power.

Another prior art method involves programming after erasure, which ensures that cells will not be over-erased beyond a set level. However, this method also carries a substantial performance penalty in time and power.

### SUMMARY OF THE INVENTION

The present invention seeks to provide methods for preventing fixed pattern programming, which may prevent large differences in the program and erase history of cells of memory arrays, as is described hereinbelow. The invention is described in detail hereinbelow with reference to memory cells of NVM arrays, and particularly to single bit, dual bit, multi-bit and multi-level NROM cells. However, it should be emphasized that the invention is not limited to NROM arrays.

There is thus provided in accordance with an embodiment of the invention a method for preventing fixed pattern programming the method including programming data into a pattern of memory cells in a memory array, and preventing fixed pattern programming by periodically scrambling the data so that the data is stored in a different pattern of memory cells in the memory array.

The data may be scrambled by periodically inverting the data. Additionally or alternatively, the data may be scrambled by periodically rearranging a physical address of the data. Additionally or alternatively, the data may be scrambled by convolving the data with a mixing pattern during programming and de-convolving the convolved data during a read operation. Additionally or alternatively, the data may be scrambled by periodically scrambling the data in accordance with a program and erase cycle counter. The data may be periodically scrambled randomly or pseudo-randomly,

In accordance with a non-limiting embodiment of the invention, the data may be scrambled as a function of a stored parameter inside the memory array. The stored parameter may be programmed in conjunction with the data.

Additionally or alternatively, the data may be scrambled as a function of a logical and/or physical address of the data.

### BRIEF DESCRIPTION OF THE DRAWINGS

The present invention will be understood and appreciated more fully from the following detailed description taken in conjunction with the appended drawings in which:
Fig. 1 is a simplified graph of erasing NROM cells by tunneling enhanced hot hole injection in the prior art:
Fig. 2 is a simplified flow diagram of an erase algorithm of the prior art for NROM devices;
Fig. 3 is a simplified graph of a prior art threshold voltage distribution of a subgroup of cells in a memory array in their native state and after erasure, wherein only a subset of the cells have been previously programmed:
Fig. 4 is a simplified graph of prior art threshold voltage distributions in a subgroup of cells in a memory array following extensive cycling of a fixed pattern (10⁵ cycles) and a subsequent programming af a checkerboard pattern.
Fig. 5 is a simplified flow chart of the programming flow in a data scrambling implementation used to prevent fixed pattern programming, in accordance with an embodiment of the invention; and
Fig. 6 is a simplified flow diagram of the read flow in the data scrambling implementation, in accordance with an embodiment of the invention.

### DETAILED DESCRIPTION OF EMBODIMENTS

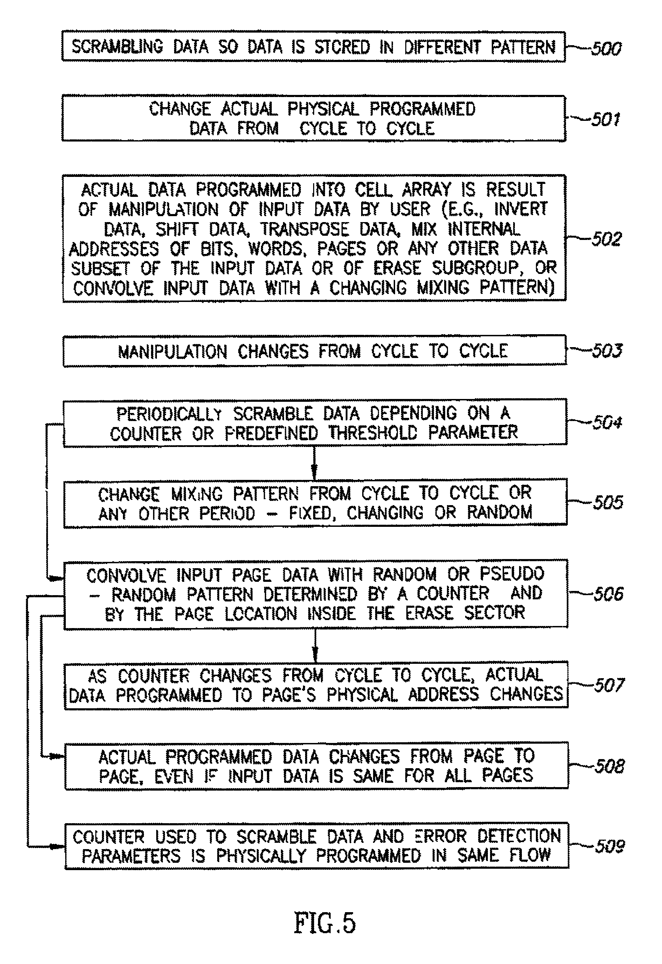

Reference is now made to Fig. 5, which illustrates a method for preventing fixed pattern programming in a non-volatile memory cell array, in accordance with an embodiment of the present invention. Specifically, Fig. 5 is a simplified flow chart of the programming flow in a data scrambling implementation, as is now explained.

In accordance with an embodiment of the present invention, after programming data into a pattern of memory cells in a memory array, fixed pattern programming is prevented by periodically scrambling the data so that the data is stored in a different pattern of memory cells in the memory array (step 500). In a non-limiting embodiment of the present invention, the actual physical programmed data is forced to change from cycle to cycle (step 501). Thus the rate at which systematic differences can develop, due to fix pattern programming, may be substantially reduced. The actual data programmed into the cell army may be a result of a manipulation of the input data by the user (step 502). This manipulation may change from cycle to cycle (step 503), or periodically change depending on a counter or a predefined threshold parameter (step 504). Such a manipulation includes, but is not limited to, inverting the input data, shifting it. transposing it, mixing the internal addresses of the bits, words, pages or any other data subset of the input data or of the erase subgroup, or convolving the input data with a changing mixing pattern. The changing mixing pattern may be from cycle to cycle or any other period, fixed, changing or random (step 505).

In accordance with a non-limning embodiment of the present invention, wherein an erase sector consists of a group of pages (each programmed individually), the input page data is convolved with a random or pseudo-random pattern determined by a counter and by the page location inside the erase sector (step 506). As the counter changes from cycle to cycle, the actual data programmed to the page's physical address also changes (step 507). Moreover, since the random or pseudo-random pattern is also determined by the page's location within the erase sector, the actual programmed data changes from page to page, even if the input data is the same for all pages (step 508). A counter used to scramble the data and error detection parameters may be physically programmed in the same flow (step 509). Error detection parameters are discussed, for example, in US Patent Application 10/695.457 (publication number US 20040136236), the disclosure of which is incorporated herein by reference, and corresponding PCT Application WO 2005/041108 "A Method Circuit And System For Read Error Detection In A Non-Volatile Memory Array", both assigned to the present assignee of the present invention. The read error rate may be determined using a variety of error rate sampling and/or error detection techniques, for example, parity bit, checksum, CRC and various other techniques. Any error detection coding and/or evaluation technique, presently known or to be devised in the future, may be applicable to present invention.

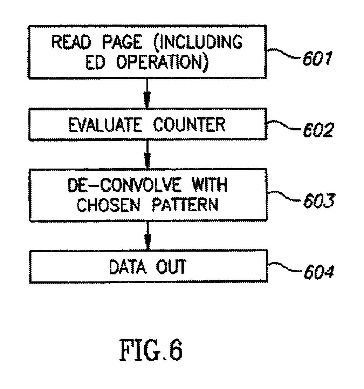

Reference is now made to Fig. 6. which illustrates the read operation for the data scrambling implementation of Fig. 5, in accordance with an embodiment of the invention. The data reliability is not affected by the scrambling scheme.

In one non-limiting embodiment, the page may be read, including the error detection parameters (step 601). If a counter has been used. the algorithm then evaluates the counter (step 602). The particular pattern used may then be deconvolved (step 603) and the data extracted (step 604).

Although the invention has been described in conjunction with specific embodiments thereof it is evident that many alternatives, modifications and variations will be apparent to those skilled in the art, Accordingly, it is intended to embrace all such alternatives, modifications and variations.

## Claims

1. A method for preventing fixed pattern programming, the method comprising:
programming data into a pattern of memory cells in a memory arrays and
preventing fixed pattern programming by periodically scrambling the data so that the data is stored in a different pattern of memory cells in the memory army.

2. The method according to claim 1, wherein periodically scrambling the data comprises periodically inverting the data.

3. The method according to claim 1, wherein periodically scrambling the data comprises periodically rearranging a physical address of said data.

4. The method according to claim 1, wherein periodically scrambling the data comprises convolving said data with a mixing pattern during programming and de-convolving the convolved data during a read operation.

5. The method according to claim 1, wherein periodically scrambling the data comprises periodically scrambling the data in accordance with a program and erase cycle counter.

6. The method according to claim 1. wherein periodically scrambling the data comprises scrambling as a function of a stored parameter inside the memory array.

7. The method according to claim 6, wherein said stored parameter is programmed in conjunction with said data.

8. The method according to claim 1, wherein periodically scrambling the data comprises scrambling as a function of a logical address of said data.

9. The method according to claim 1, wherein periodically scrambling the data comprises scrambling as a function of a physical address of said data.

10. The method according to any of claims 1 to 9, wherein the data is periodically scrambled randomly.

11. The method according to any of claims 1 to 9, wherein the data is periodically scrambled pseudo-randomly.
